# EUROPEAN PATENT APPLICATION

(11) **EP 4 478 866 A1**
(43) Date of publication of application: **18.12.2024**
(21) Application number: 24182082.8
(22) Date of filing: 13.06.2024
(51) Int. Cl.: H10K 59/40, H10K 59/65, H10K 59/80, H10K 59/88

(54) **ELECTRONIC DEVICE AND METHOD OF MANUFACTURING THE SAME**

(30) Priority: 15.06.2023 KR 20230076710
(71) Applicant: Samsung Display Co., Ltd., Gyeonggi-Do (KR)
(72) Inventor: LEE, Jeongho, Yongin-si (KR); LEE, Soomin, Yongin-si (KR); CHOI, Soo-Hyun, Yongin-si (KR)
(74) Representative: Marks & Clerk LLP

(57) **Abstract**

An electronic device includes: a display panel comprising a base layer comprising a first area and a second area surrounding the first area, pixels on the base layer overlapping the second area, and an encapsulation layer covering the pixels and provided with a module hole defined therethrough and overlapping the first area; a cover layer comprising an organic material and on the display panel; an anti-reflective layer on the cover layer; an electronic module overlapping the module hole; and a window on the anti-reflective layer, wherein the first area comprises a dam area adjacent to the second area and surrounding the module hole and a margin area between the module hole and the dam area, and the cover layer overlaps the dam area and the second area and is spaced apart from the margin area.

## Description

### BACKGROUND

### 1. Field

Aspects of some embodiments of the present disclosure relate to an electronic device and a method of manufacturing the electronic device.

### 2. Description of the Related Art

An electronic device is activated in response to electrical signals. The electronic device may include devices configured by various electronic components, such as a display panel configured to display images or an input sensor configured to sense an external input. The electronic components may be electrically connected to each other by signal lines arranged in various ways.

The above information disclosed in this Background section is only for enhancement of understanding of the background and therefore the information discussed in this Background section does not necessarily constitute prior art.

### SUMMARY

Aspects of some embodiments of the present disclosure relate to an electronic device with improved display quality and a method of manufacturing the electronic device.

Aspects of some embodiments of the present disclosure include an electronic device with relatively improved display quality.

Aspects of some embodiments of the present disclosure include a method of manufacturing the electronic device.

Aspects of some embodiments of the present disclosure include an electronic device including a display panel including a base layer including a first area and a second area surrounding the first area, pixels on the base layer overlapping the second area, and an encapsulation layer covering the pixels and provided with a module hole defined therethrough and overlapping the first area, a cover layer including an organic material and on the display panel, an anti-reflective layer on the cover layer, an electronic module overlapping the module hole, and a window on the anti-reflective layer. According to some embodiments, the first area includes a dam area adjacent to the second area and surrounding the module hole and a margin area between the module hole and the dam area, and the cover layer overlaps the dam area and the second area and is spaced apart from the margin area.

According to some embodiments, the cover layer overlapping the second area has a thickness equal to or greater than about 2 micrometers and equal to or smaller than about 5 micrometers.

According to some embodiments, the cover layer overlapping the first area has a thickness greater than a thickness of the cover layer overlapping the second area.

According to some embodiments, the encapsulation layer includes a first inorganic layer covering the pixels, a second inorganic layer on the first inorganic layer, and an organic layer between the first inorganic layer and the second inorganic layer.

According to some embodiments, the cover layer is in contact with the second inorganic layer.

According to some embodiments, the first inorganic layer and the second inorganic layer are in contact with each other in the margin area.

According to some embodiments, the display panel further includes an intermediate layer between the second inorganic layer and the cover layer and extending from the second area to the margin area via the dam area, and the intermediate layer includes an inorganic material.

According to some embodiments, the organic layer overlapping the second area has a thickness equal to or greater than about 5 micrometers and equal to or smaller than about 10 micrometers.

According to some embodiments, the electronic device further includes an input sensor including a first sensing insulating layer on the encapsulation layer, a second sensing insulating layer on the first sensing insulating layer, a first conductive layer on the second sensing insulating layer, a third sensing insulating layer covering the first conductive layer and on the second sensing insulating layer, and a second conductive layer on the third sensing insulating layer. The cover layer covers the second conductive layer and is on the third sensing insulating layer.

According to some embodiments, the first sensing insulating layer and the third sensing insulating layer overlap the second area and the dam area and are spaced apart from the margin area, and the second sensing insulating layer extends from the second area to the margin area via the dam area.

According to some embodiments, the first sensing insulating layer and the third sensing insulating layer have a thickness greater than a thickness of the cover layer.

According to some embodiments, the first sensing insulating layer and the third sensing insulating layer include an organic material, and the second sensing insulating layer includes an inorganic material.

According to some embodiments, the electronic device further includes dam patterns in the dam area and surrounding the module hole, and each of the dam patterns includes a tip portion protruding from a side surface of the dam pattern and including a conductive material.

According to some embodiments, the tip portion is covered by the first inorganic layer.

According to some embodiments, a boundary of the organic layer in the dam area is defined by one of the dam patterns.

According to some embodiments, the electronic device further includes a first adhesive layer between the cover layer and the anti-reflective layer and a second adhesive layer between the anti-reflective layer and the window, and the first and second adhesive layers include at least one of an optically clear adhesive, an optically clear adhesive resin, or a pressure sensitive adhesive.

According to some embodiments, the window further includes a bezel pattern on a rear surface of the window overlapping the first area and provided with an opening defined therethrough and overlapping the module hole.

Aspects of some embodiments of the present disclosure include a method of manufacturing an electronic device. According to some embodiments, the method includes providing a display panel including a base layer in which a first area including a hole processing area, a margin area surrounding the hole processing area, and a dam area surrounding the margin area is defined, a pixel formed on the base layer, and an encapsulation layer covering the pixel, coating an organic material on the display panel to form a cover layer, patterning the cover layer overlapping the hole processing area and the margin area, irradiating a laser beam on a rear surface of the base layer along a boundary between the hole processing area and the margin area, and spraying an etchant to the boundary to form a module hole. According to some embodiments, the patterning of the cover layer is performed by a photoresist process.

According to some embodiments, the encapsulation layer includes a first inorganic layer, an organic layer on the first inorganic layer, and a second inorganic layer on the organic layer, the first inorganic layer and the second inorganic layer are in contact with each other in the margin area, and the second inorganic layer overlapping the margin area is exposed via an opening formed through the cover layer in the patterning of the cover layer.

According to some embodiments, the organic layer has a thickness equal to or greater than about 5 micrometers and equal to or smaller than about 10 micrometers, and the cover layer has a thickness equal to or greater than about 2 micrometers and equal to or smaller than about 5 micrometers.

At least some of the above and other features of the present invention are set out in the claims.

Some embodiments may be capable of adjusting the thickness of the organic layer included in the encapsulation layer, and thus, the waviness generated in an area where the thickness of the organic layer is varied may be relatively improved.

According to some embodiments, a pre-ablation process performed to remove an organic layer formed by an inkjet process is not required in a process of forming the module hole, meaning that a manufacturing cost of the electronic device is reduced.

### BRIEF DESCRIPTION OF THE DRAWINGS

The above and other aspects of some embodiments of the present disclosure will become readily apparent by reference to the following detailed description when considered in conjunction with the accompanying drawings wherein:
FIG. 1 is a perspective view showing an electronic device according to some embodiments of the present disclosure;
FIG. 2 is an exploded perspective view showing an electronic device according to some embodiments of the present disclosure;
FIG. 3 is a block diagram showing an electronic device according to some embodiments of the present disclosure;
FIG. 4 is a plan view of a display panel at a portion adjacent to a hole according to some embodiments of the present disclosure;
FIG. 5 is a cross-sectional view taken along a line I-I' of FIG. 2;
FIG. 6 is a cross-sectional view showing a display module according to some embodiments of the present disclosure;
FIG. 7 is a cross-sectional view showing a display module according to some embodiments of the present disclosure;
FIGS. 8 to 12 are cross-sectional views illustrating a method of manufacturing an electronic device according to some embodiments of the present disclosure; and
FIGS. 13 to 17 are cross-sectional views illustrating a method of manufacturing an electronic device according to some embodiments of the present disclosure.

### DETAILED DESCRIPTION

In the present disclosure, it will be understood that when an element (or area, layer, or portion) is referred to as being "on", "connected to" or "coupled to" another element or layer, it can be directly on, connected or coupled to the other element or layer or intervening elements or layers may be present.

Like numerals refer to like elements throughout. In the drawings, the thickness, ratio, and dimension of components are exaggerated for effective description of the technical content. As used herein, the term "and/or" may include any and all combinations of one or more of the associated listed items.

It will be understood that, although the terms first, second, etc. may be used herein to describe various elements, these elements should not be limited by these terms. These terms are only used to distinguish one element from another element. Thus, a first element discussed below could be termed a second element without departing from the teachings of the present disclosure. As used herein, the singular forms, "a", "an" and "the" are intended to include the plural forms as well, unless the context clearly indicates otherwise.

Spatially relative terms, such as "beneath", "below", "lower", "above", "upper" and the like, may be used herein for ease of description to describe one element or feature's relationship to other elements or features as shown in the figures.

It will be further understood that the terms "include" and/or "including", when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms including technical and scientific terms used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, aspects of some embodiments of the present disclosure will be described in more detail with reference to accompanying drawings.

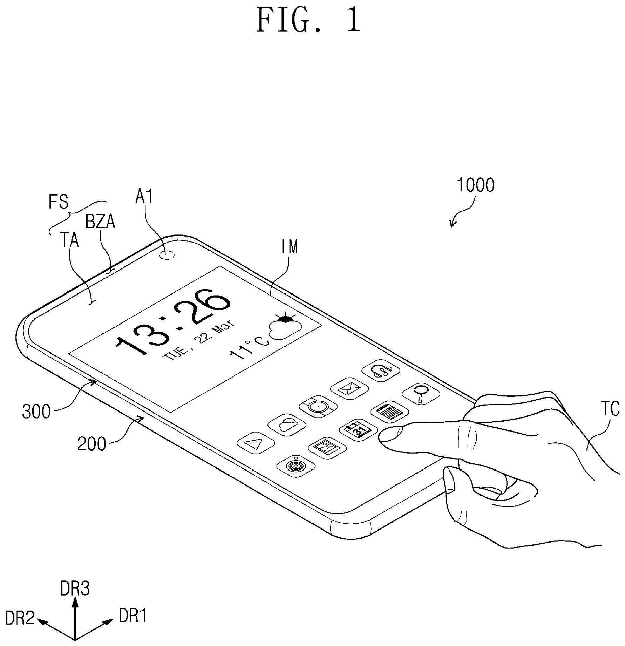

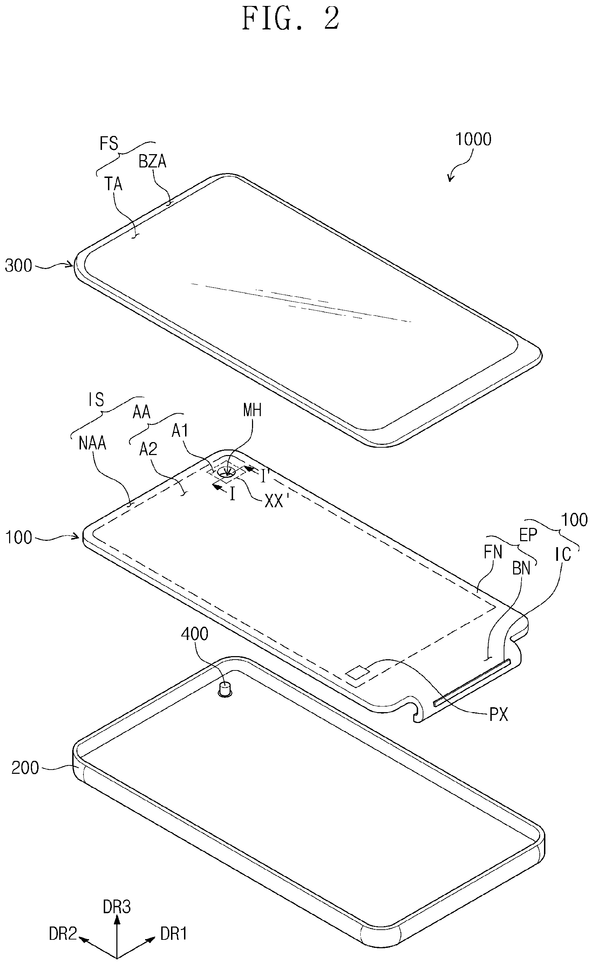

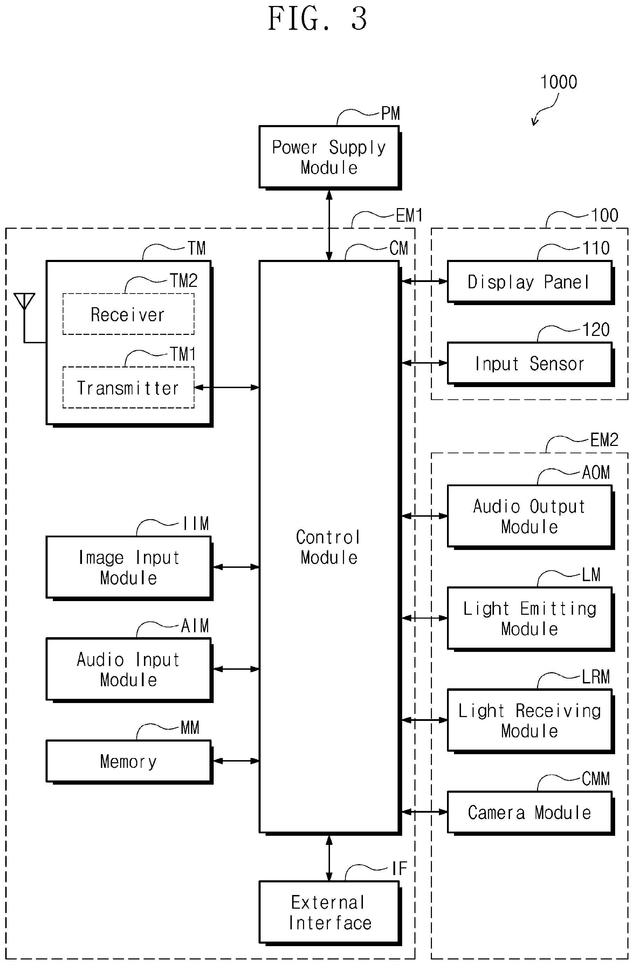

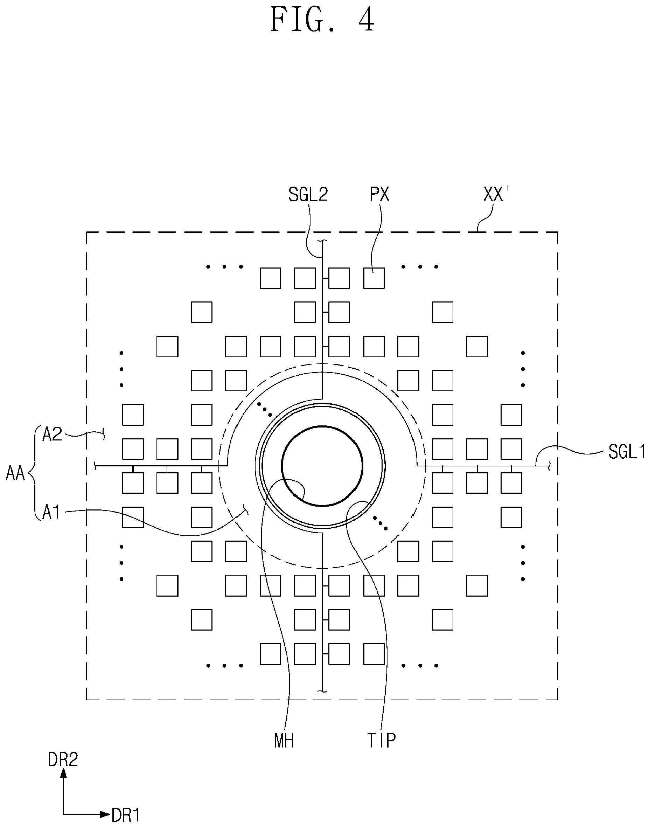

FIG. 1 is a perspective view showing an electronic device 1000 according to some embodiments of the present disclosure. FIG. 2 is an exploded perspective view showing the electronic device 1000 according to some embodiments of the present disclosure. FIG. 3 is a block diagram showing the electronic device 1000 according to some embodiments of the present disclosure. FIG. 4 is a plan view of a display panel 110 (refer to FIG. 3) at a portion adjacent to a module hole MH according to some embodiments of the present disclosure.

The electronic device 1000 may be a device activated in response to an electrical signal. The electronic device 1000 may include various embodiments. For example, the electronic device 1000 may include a tablet computer, a notebook computer, a computer, a smart television, or the like. In the present embodiments, a smartphone will be described as a representative example of the electronic device 1000, but embodiments according to the present disclosure are not limited thereto.

Referring to FIGS. 1 and 2, the electronic device 1000 may display one or more images IM through a display surface FS, which is parallel to a plane defined by a first direction DR1 and a second direction DR2. The images IM may be displayed toward a third direction DR3, which is perpendicular to the plane defined by the first direction DR1 and the second direction DR2. The display surface FS, through which the images IM are displayed, may correspond to a front surface FS of the electronic device 1000 and a front surface FS of a window 300. Hereinafter, the display surface FS and the front surface FS of the electronic device 1000 and the front surface FS of the window 300 will be assigned with the same reference numeral. The images IM may include still images (e.g., static images) as well as dynamic or video images. FIG. 1 shows a clock widget and application icons as a representative example of the image IM.

In the present embodiments, front (or upper) and rear (or lower) surfaces of each member of the electronic device 1000 may be defined with respect to a direction in which the image IM is displayed. The front and rear surfaces may be opposite to each other in the third direction DR3, and a normal line direction of each of the front and rear surfaces may be substantially parallel to the third direction DR3. A separation distance between the front and rear surfaces of the electronic device 1000 may correspond to a thickness in the third direction DR3 of the electronic device 1000.

According to some embodiments, the electronic device 1000 may sense a user input (or an external input) TC applied thereto from the outside. The user input TC may include various types of external inputs, such as a part of the user's body, a stylus, light, heat, or pressure. In the present embodiments, the user input TC is shown as a hand of the user applied to the front surface FS of the electronic device 1000.

However, this is merely one example, and the electronic device 1000 may sense the user input TC applied to a side or rear surface of the electronic device 1000 depending on its structure, and it should not be limited to a specific embodiment.

According to some embodiments, the electronic device 1000 may include a first area A1 defined in a transmission area TA. The first area A1 may be an area of a display module 100, which is described later, overlapping an electronic module 400. A module hole MH of the display module 100 may be defined in the first area A1.

The electronic device 1000 may receive external signals required for the electronic module 400 via the first area A1 or may provide signals output from the electronic module 400 to the outside via the first area A1. According to the present disclosure, as the first area A1 is defined in the transmission area TA, a size of a bezel area BZA may be reduced compared when the first area A1 is defined in the bezel area BZA.

Referring to FIG. 2, the electronic device 1000 may include the display module 100, a housing 200, the window 300, and the electronic module 400. The window 300 and the housing 200 may be coupled to each other to provide an exterior of the electronic device 1000.

The window 300 may include an insulating panel. For example, the window 300 may include a glass material, a plastic material, or a combination thereof. The front surface FS of the window 300 may define the front surface FS of the electronic device 1000 as described above. The window 300 may include the transmission area TA and the bezel area BZA adjacent to the transmission area TA. The transmission area TA may be an optically transparent area. For example, the transmission area TA may be an area having a visible light transmittance of about 90% or more. The bezel area BZA may be an area having a relatively lower transmittance as compared with the transmission area TA. The bezel area BZA may define a shape of the transmission area TA.

The bezel area BZA may have a color (e.g., a set or predetermined color). The bezel area BZA may be defined by a bezel layer provided separately from a transparent substrate defining the transmission area TA or may be defined by an ink layer formed by being inserted into or by printing a color on the transparent substrate.

The display module 100 may include an electronic panel EP and a driving circuit IC. The electronic panel EP may display the image IM and may sense the user input TC. The electronic panel EP may include a front surface IS in which an active area AA and a peripheral area NAA are defined. The active area AA may be an area activated in response to an electrical signal. The electronic panel EP may be defined as including a display panel 110 and an input sensor 120 among components included in the display module 100.

According to some embodiments, the active area AA may be an area where the image IM is displayed and the external input TC is sensed. The active area AA may be an area in which a plurality of pixels PXᵢⱼ is arranged.

The active area AA may overlap at least a portion of the transmission area TA. As an example, the transmission area TA may overlap all or at least a portion of the active area AA. Accordingly, a user may view the image IM or may provide the external input TC via the transmission area TA, however, this is merely one example. That is, an area through which the image IM is displayed and an area through which the external input TC is sensed may be separated from each other in the active area AA, and they should not be limited to a particular embodiment.

The peripheral area NAA may be covered by the bezel area BZA. The peripheral area NAA may be located adjacent to the active area AA. The peripheral area NAA may surround the active area AA. The peripheral area NAA may be an area through which the image IM is not displayed. A driving circuit or a driving line may be located in the peripheral area NAA to drive the active area AA.

According to some embodiments, a portion of the peripheral area NAA of the electronic panel EP may be bent. As an example, the electronic panel EP may include a flat portion FN and a bending portion BN. The flat portion FN may be assembled to be substantially parallel to a plane defined by the first direction DR1 and the second direction DR2. The active area AA may be defined in the flat portion FN.

The bending portion BN may extend from the flat portion FN and may be bent with respect to an imaginary bending axis. The bending portion BN may be assembled to be bent from the flat portion FN and located on a rear side of the flat portion FN. Because the bending portion BN overlaps the flat portion FN in a plane when being assembled, the bezel area BZA of the electronic device 1000 may decrease. Meanwhile, this is merely one example, and the bending portion BN may be omitted from the electronic panel EP.

The driving circuit IC may be mounted on the bending portion BN. The driving circuit IC may be provided in a chip form, however, it should not be limited thereto or thereby. According to some embodiments, the driving circuit IC may be electrically connected to the electronic panel EP via a flexible film after being provided to a separate circuit board.

The driving circuit IC may be electrically connected to the active area AA and may apply electrical signals to the active area AA. As an example, the driving circuit IC may include a data driving circuit and may apply data signals to pixels arranged in the active area AA. According to some embodiments, the driving circuit IC may include a touch driving circuit and may be electrically connected to the input sensor located in the active area AA. Meanwhile, this is merely an example, and according to some embodiments, the driving circuit IC may be designed to include a variety of circuits in addition to the above-mentioned circuits or to apply a variety of electrical signals to the active area AA, and it should not be particularly limited.

The electronic device 1000 may further include a main circuit board electrically connected to the electronic panel EP and the driving circuit IC. The main circuit board may include various driving circuits to drive the electronic panel EP or a connector to provide a power. The main circuit board may be a rigid printed circuit board (PCB), however, according to some embodiments, the main circuit board may be a flexible circuit board, and it should not be particularly limited.

The electronic module 400 may be located under the display module 100. The electronic module 400 may receive the external input via the first area A1 or may output signals via the first area A1. According to the present disclosure, as the first area A1 having a relatively high transmittance is defined in the active area AA, the electronic module 400 may be arranged to overlap the active area AA. Accordingly, the increase in size of the bezel area BZA may be prevented.

The housing 200 may be coupled with the window 300 to provide an inner space (e.g., a set or predetermined inner space) and may define the exterior of the electronic device 1000. The components of the electronic device 1000 such as the display module 100 and the electronic module 400 may be accommodated in the inner space.

The housing 200 may have a material with a relatively high rigidity. For example, the housing 200 may include a glass, plastic, or metal material or a plurality of frames and/or plates of combinations thereof. The housing 200 may stably protect the components of the electronic device 1000 accommodated in the inner space from external impacts.

Referring to FIG. 3, the electronic device 1000 may include the display module 100, a power supply module PM, a first electronic module EM1, and a second electronic module EM2. The display module 100, the power supply module PM, the first electronic module EM1, and the second electronic module EM2 may be electrically connected to each other.

FIG. 3 shows the display panel 110 and the input sensor 120, which are included in the electronic panel EP (refer to FIG. 2) among components of the display module 100. The display panel 110 may include configurations to generate the images IM. The image IM generated by the display panel 110 may be displayed on the display surface FS and may be visible to the user through the transmission area TA from the outside. The input sensor 120 may sense the external input TC applied thereto from the outside. As described above, the input sensor 120 may sense the external input TC applied to the window 300.

The power supply module PM may supply a power required for the overall operation of the electronic device 1000. The power supply module PM may include a conventional battery module.

The first electronic module EM1 and the second electronic module EM2 may include various functional modules to operate the electronic device 1000. The first electronic module EM1 may be mounted directly on a mother board that is electrically connected to the electronic panel EP or may be electrically connected to the mother board via a connector after being mounted on a separate substrate.

The first electronic module EM1 may include a control module CM, a wireless communication module TM, an image input module IIM, an audio input module AIM, a memory MM, and an external interface IF. Some modules among the modules may be electrically connected to the mother board through a flexible circuit board without being mounted on the mother board.

The control module CM may control an overall operation of the electronic device 1000. The control module CM may be, but not limited to, a microprocessor. For example, the control module CM may activate or deactivate the display module 100. The control module CM may control other modules, such as the image input module IIM, the audio input module AIM, or the like, based on a touch signal provided from the electronic panel EP.

The wireless communication module TM may transmit/receive a wireless signal to/from other terminals using a Bluetooth or WiFi link. The wireless communication module TM may transmit/receive a voice signal using a general communication line. The wireless communication module TM may include a transmitter TM1 that modulates a signal to be transmitted and transmits the modulated signal and a receiver TM2 that demodulates the signal applied thereto.

The image input module IIM may process an image signal and may convert the image signal into image data that may be displayed through the electronic panel EP. The audio input module AIM may receive an external sound signal through a microphone in a record mode or a voice recognition mode and may convert the external sound signal to electrical voice data.

The external interface IF may serve as an interface between the control module CM and external devices, such as an external charger, a wired/wireless data port, a card socket e.g., a memory card and a SIM/UIM card, etc.

The second electronic module EM2 may include an audio output module AOM, a light emitting module LM, a light receiving module LRM, and a camera module CMM. The components may be electrically connected to the electronic panel EP after being directly mounted on the mother board, may be electrically connected to the electronic panel EP via a connector after being mounted on a separate substrate, or may be electrically connected to the first electronic module EM1.

The audio output module AOM may convert the sound data provided from the wireless communication module TM or the sound data stored in the memory MM and may output the converted sound data to the outside.

The light emitting module LM may generate a light and may output the light. The light emitting module LM may emit an infrared ray. The light emitting module LM may include an LED element. The light receiving module LRM may sense the infrared ray. The light receiving module LRM may be activated when the infrared ray having a level (e.g., a set or predetermined level) or higher is sensed. The light receiving module LRM may include a complementary metal oxide semiconductor (CMOS) sensor. The infrared ray generated by and output from the light emitting module LM may be reflected by an external object, e.g., a user's finger or face, and the reflected infrared ray may be incident into the light receiving module LRM. The camera module CMM may take an image of an external object.

According to some embodiments, the electronic module 400 may include at least one of the components of the second electronic module EM2. For example, the electronic module 400 may include at least one of a camera, a speaker, a light sensing sensor, or a heat sensing sensor. The electronic module 400 may sense the external object via the first area A1 or may provide a sound signal, such as a voice, to the outside through the first area A1. In addition, the electronic module 400 may include a plurality of components, and it should not be limited to a particular embodiment. According to some embodiments, the electronic module 400 may be attached to the electronic panel EP by a separate adhesive.

FIG. 4 shows a portion XX' of the active area AA of the display panel 110 (refer to FIG. 3), which is adjacent to the module hole MH.

Referring to FIG. 4, among the pixels PX included in the display panel 110, most of the pixels PX may be arranged in a second area A2, and some of the pixels PX may be arranged in the second area A2 along a boundary between the first area A1 and the second area A2 and may be spaced apart from the first area A1.

The module hole MH may be defined in the active area AA. Accordingly, at least some of the pixels PX may be arranged adjacent to the module hole MH and may be spaced apart from each other with the module hole MH interposed therebetween.

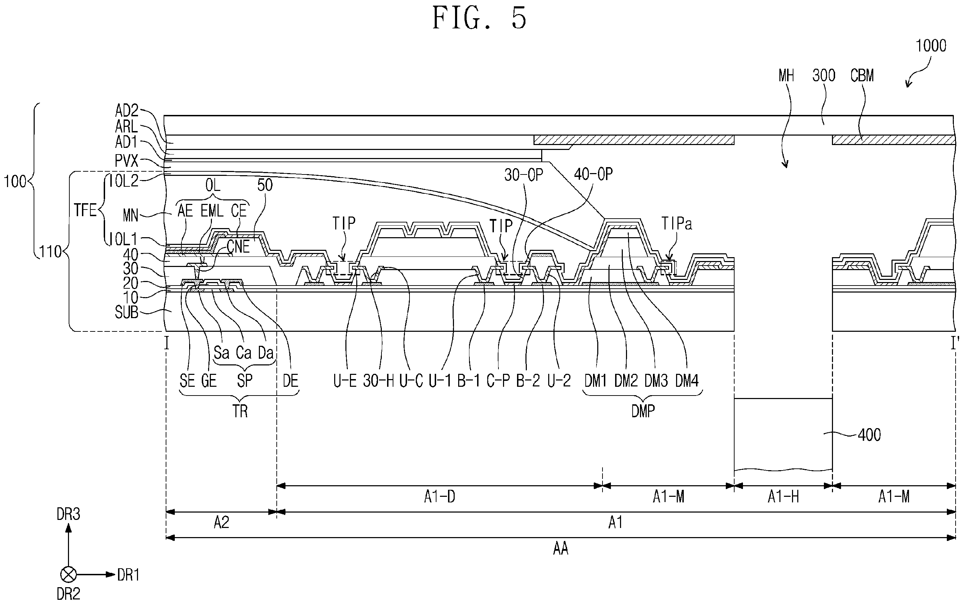

At least one tip portion TIP may be defined in the first area A1 of the display panel 110. The tip portion TIP of the electronic device 1000 (refer to FIG. 2) may block a path through which moisture and/or oxygen enters from the module hole MH into the pixels PX. That is, elements formed after the tip portion TIP is formed and including an organic material may be disconnected by the tip portion TIP. As an example, a light emitting layer EML described with reference to FIG. 5 may be disconnected in an area overlapping the tip portion TIP, and thus, the path through which the moisture and/or oxygen enters from the module hole MH into the light emitting layer EML may be blocked. Accordingly, a display quality of the display panel 110 may be relatively improved.

The tip portion TIP may overlap the first area A1 and may surround at least a portion of the module hole MH when viewed in a plane. The tip portion TIP may be defined closer to the second area A2 than the module hole MH is. When viewed in the plane, the tip portion TIP may have a closed-line shape to surround the module hole MH. The tip portion TIP may be provided in plural, and each of the tip portions may surround the module hole MH.

According to some embodiments, a filling portion may be located in the module hole MH. The filling portion may include a polymer resin. As the filling portion is located in the module hole MH, the filling portion may provide a flat surface for elements located thereon in the module hole MH.

In FIG. 4, the tip portion TIP and the module hole MH have a circular shape when viewed in the plane, however, the tip portion TIP and the module hole MH may have different shapes from each other. In addition, each of the tip portion TIP and the module hole MH may have a closed-line shape including a polygonal shape, an oval shape, or at least a curved line shape, or a shape including a plurality of patterns that is partially disconnected, however, it should not be particularly limited.

A portion of each of signal lines SGL1 and SGL2 connected to the pixels PX may be located in the first area A1. The signal lines SGL1 and SGL2 may be connected to the pixels PX, which are spaced apart from each other with the module hole MH interposed therebetween, via the first area A1. For the convenience of explanation, FIG. 4 shows two signal lines SGL1 and SGL2 among the signal lines connected to the pixels PX as a representative example.

A first signal line SGL1 may extend in the first direction DR1. The first signal line SGL1 may be connected to the pixels arranged in the same row along the first direction DR1 among the pixels. The first signal line SGL1 will be described as corresponding to one of scan lines connected to the pixels PX as a representative example.

Some of the pixels PX connected to the first signal line SGL1 may be located at a left side with respect to the module hole MH, and the other pixels connected to the first signal line SGL1 may be located at a right side with respect to the module hole MH. Therefore, the pixels arranged in the same row and connected to the first signal line SGL1 may be turned on or off in response to the same scan signal even though some pixels are omitted around the module hole MH.

A second signal line SGL2 may extend in the second direction DR2. The second signal line SGL2 may be connected to the pixels arranged in the same column in the second direction DR2 among the pixels PX. The second signal line SGL2 will be described as corresponding to one of data lines as a representative example.

Some pixels of the pixels connected to the second signal line SGL2 may be located at an upper side with respect to the module hole MH, and the other pixels connected to the second signal line SGL2 may be located at a lower side with respect to the module hole MH. Therefore, the pixels arranged in the same column and connected to the second signal line SGL2 may receive the data signal through the same line even though some pixels are omitted around the module hole MH.

At least one of the first signal line SGL1 or the second signal line SGL2 may be disconnected at a point where the first signal line SGL1 intersects with the second signal line SGL2 in the first area A1, and a connection pattern, which is located on a layer different from the disconnected signal line, may be further provided to connect disconnected portions of the disconnected signal line. However, the connection between the pixels PX spaced apart from each other with the module hole MH interposed therebetween should not be limited thereto or thereby.

FIG. 5 is a cross-sectional view taken along a line I-I' of FIG. 2. In FIG. 5, the housing 200 described with reference to FIG. 2 is omitted.

The display module 100 may include the first area A1 and the second area A2 surrounding at least a portion of the first area A1. The first area A1 may include a dam area A1-D, a margin area A1-M, and a hole area A1-H.

The dam area A1-D may be adjacent to the second area A2. The margin area A1-M may be located between the dam area A1-D and the hole area A1-H. The hole area A1-H may overlap the module hole MH.

The display panel 110 may include a base layer SUB, a circuit element layer, a display element layer, and an encapsulation layer TFE. In the present disclosure, the "circuit element layer" may be defined as including a transistor TR and insulating layers 10, 20, 30, and 40. The "display element layer" may be defined as including a pixel definition layer 50 and a light emitting element OL.

The base layer SUB may provide a base surface on which display elements and signal lines of the display panel 110 are located. An insulating layer, a semiconductor layer, and a conductive layer may be formed on the base layer SUB by a coating or depositing process. Then, the insulating layer, the semiconductor layer, and the conductive layer may be selectively patterned by a photolithography process. Thus, the semiconductor pattern, the conductive pattern, and the signal line may be formed.

The base layer SUB may be provided in the form of a multi-layered film in which an inorganic layer and an organic layer are alternately stacked, however, it should not be limited thereto or thereby. According to some embodiments, the base layer SUB may have a single-layer structure. In this case, the base layer SUB may include a synthetic resin film or may include one of glass and metal materials. The synthetic resin film may include a thermosetting resin. In particular, the synthetic resin film may be a polyimide-based resin layer, and materials for the synthetic resin film should not be particularly limited. In the present disclosure, the first area A1 and the second area A2 are defined in the base layer SUB.

The transistor TR may be located on the base layer SUB. The transistor TR may include a semiconductor pattern SP, a source electrode SE, a drain electrode DE, and a gate electrode GE.

The semiconductor pattern SP may be located on the base layer SUB. The semiconductor pattern SP may include a silicon semiconductor. As an example, the semiconductor pattern SP may include a crystalline silicon semiconductor, a polysilicon semiconductor, or an amorphous silicon semiconductor, however, it should not be limited thereto or thereby. The semiconductor pattern SP may include an oxide semiconductor. The semiconductor pattern SP may include a variety of materials as long as the semiconductor pattern SP has a semiconductor property, and it should not be particularly limited.

The circuit element layer may be located on the base layer SUB. The circuit element layer may include the transistor TR and the insulating layers 10, 20, 30, and 40.

The semiconductor pattern SP of the transistor TR may be located on the base layer SUB. The semiconductor pattern SP may include a source area Sa, a drain area Da, and a channel area Ca. The semiconductor pattern SP may include a plurality of areas distinguished from each other depending on a conductivity. As an example, the semiconductor pattern SP may have different electrical properties depending on whether it is doped or not, whether it is doped with an N-type dopant or a P-type dopant, or whether a metal oxide is reduced or not. A portion of the semiconductor pattern, which has a relatively high conductivity, may serve as an electrode or a signal line and may correspond to the source area Sa and the drain area Da of the transistor TR. A non-doped or non-reduced portion with a relatively low conductivity may correspond to the channel area Ca (or an active area) of the transistor TR.

The circuit element layer may further include a barrier layer and/or a buffer layer located between the semiconductor pattern SP and the base layer SUB. The barrier layer may include an inorganic material. As an example, the barrier layer may include at least one of silicon oxide, aluminium oxide, titanium oxide, silicon nitride, silicon oxynitride, zirconium oxide, or hafnium oxide.

The buffer layer may be located on the barrier layer or may be located directly on the base layer SUB when the barrier layer is omitted. The buffer layer may improve an adhesive force between the barrier pattern and the semiconductor pattern and/or between the barrier pattern and the conductive pattern. The buffer layer may include a silicon oxide layer and a silicon nitride layer. In addition, the buffer layer may have a single-layer or multi-layer structure of silicon oxynitride, however, it should not be limited thereto or thereby.

A first insulating layer 10 may be located on the base layer SUB and may cover the semiconductor pattern SP of the transistor TR. The first insulating layer 10 may include an inorganic layer having a single-layer or multiple-layer structure.

The gate electrode GE may be located on the first insulating layer 10. The gate electrode GE may overlap the channel area Ca when viewed in the plane. The gate electrode GE may serve as a mask in a process of doping the semiconductor pattern SP.

A second insulating layer 20 may be located on the first insulating layer 10 and may cover the gate electrode GE. The second insulating layer 20 may include an inorganic layer having a single-layer or multiple-layer structure.

The source electrode SE and the drain electrode DE may be located on the second insulating layer 20. The source electrode SE may be connected to the source area Sa of the semiconductor pattern SP via a contact hole defined through the first and second insulating layers 10 and 20. The drain electrode DE may be connected to the drain area Da of the semiconductor pattern SP via a contact hole defined through the first and second insulating layers 10 and 20. The source electrode SE and the drain electrode DE may be arranged to be spaced apart from each other on the second insulating layer 20.

A third insulating layer 30 may be located on the second insulating layer 20 and may cover the source electrode SE and the drain electrode DE. The third insulating layer 30 may include an organic layer. The third insulating layer 30 including the organic layer may compensate for a step difference between components located thereunder and may provide a flat surface.

The circuit element layer may further include a connection electrode CNE. The connection electrode CNE may be located on the third insulating layer 30. The connection electrode CNE may electrically connect the transistor TR and the light emitting element OL. The connection electrode CNE may be connected to the drain electrode DE via a contact hole defined through the third insulating layer 30, however, it should not be limited thereto or thereby. According to some embodiments, the circuit element layer may further include an additional electrode that connects the connection electrode CNE and the light emitting element OL, is located on an additional insulating layer located between the third insulating layer 30 and a fourth insulating layer 40, and is connected to the connection electrode CNE through the additional insulating layer, however, the present disclosure should not be particularly limited.

The fourth insulating layer 40 may be located on the third insulating layer 30 and may cover the connection electrode CNE. The fourth insulating layer 40 may include an organic layer. The fourth insulating layer 40 including the organic layer may provide a flat surface.

Meanwhile, a configuration of the circuit element layer should not be limited to that shown in FIG. 5, and the circuit element layer may further include an insulating layer. At least one or more insulating layers may be additionally provided to be located between the first to fourth insulating layers 10 to 40, under the first insulating layer 10, or on the fourth insulating layer 40. The circuit element layer may have a variety of cross-sectional structures according to a circuit design and should not be particularly limited.

The display element layer may be located on the circuit element layer. The display element layer may include the light emitting element OL and the pixel definition layer 50.

The light emitting element OL may be located in the second area A2. The light emitting element OL may include a first electrode AE, the light emitting layer EML, and a second electrode CE. The light emitting element OL may further include a hole control layer located between the first electrode AE and the light emitting layer EML and an electron control layer located between the light emitting layer EML and the second electrode CE.

Each of the second electrode CE, the hole control layer, and the electron control layer may be entirely formed over the first area A1 and the second area A2. Each of the second electrode CE, the hole control layer, and the electron control layer may be entirely formed over the active area AA through a deposition process using an open mask. Therefore, the second electrode CE, the hole control layer, and the electron control layer may be referred to as a common layer.

The first electrode AE may be an anode electrode, and the second electrode CE may be a cathode electrode. As an example, the light emitting element OL may include an organic light emitting element, a quantum dot light emitting element, a micro-LED, or a nano-LED, however, it should not be limited thereto or thereby. The light emitting element OL may include various embodiments as long as a light may be generated or an amount of the light may be controlled according to an electrical signal.

The first electrode AE may be located on the fourth insulating layer 40. The first electrode AE may be connected to the connection electrode CNE via a contact hole defined through the fourth insulating layer 40. The first electrode AE may be electrically connected to the drain area Da of the transistor TR via the connection electrode CNE and the drain electrode DE.

The pixel definition layer 50 may be located on the fourth insulating layer 40. The pixel definition layer 50 be provided with a light emitting opening defined therethrough to expose at least a portion of the first electrode AE. The portion of the first electrode AE, which is exposed through the light emitting opening, may correspond to a light emitting area.

The pixel definition layer 50 may be formed of a polymer resin. As an example, the pixel definition layer 50 may include a polyacrylate-based resin or a polyimide-based resin. The pixel definition layer 50 may further include an inorganic material in addition to the polymer resin. According to some embodiments, the pixel definition layer 50 may include an inorganic material. As an example, the pixel definition layer 50 may include silicon nitride (SiNₓ), silicon oxide (SiOₓ), or silicon oxynitride (SiOₓN_{y}).

The pixel definition layer 50 may include a light absorbing material. The pixel definition layer 50 may include a black coloring agent. The black coloring agent may include a black pigment or a black dye. The black coloring agent may include a metal material, such as carbon black, chrome, etc., or an oxide thereof.

The light emitting layer EML may be located on the first electrode AE. The light emitting layer EML may be located in an area corresponding to the light emitting opening defined through the pixel definition layer 50. That is, the light emitting layer EML may be provided to each of the pixels PX (refer to FIG. 4), and the light emitting layer EML of the pixels PX may be provided in the form of a light emitting pattern to be separately provided in each pixel when viewed in the plane. The light emitting layers EML may be formed through a deposition process using a mask in which a pattern is formed, e.g., a fine metal mask (FMM), different from the common layer.

The light emitting layer EML may provide a light with a color (e.g., a set or predetermined color). The light emitting layer EML may emit a light having one of red, blue, and green colors, however, it should not be limited thereto or thereby. The light emitting layer EML may generate a white light by a combination of light emitting materials respectively generating the red, green, and blue colors.

The light emitting layer EML may include an organic light emitting material and/or an inorganic light emitting material. As an example, the light emitting layer EML may include a fluorescent or phosphorescent material, an organometallic complex light emitting material, or a quantum dot. The light emitting layer EML may have a multi-layer structure. As an example, the light emitting layer EML may include a main light emitting layer and an auxiliary light emitting layer located on the main light emitting layer. The main light emitting layer and the auxiliary light emitting layer may have different thicknesses depending on a wavelength of the light emitted from the main light emitting layer and the auxiliary light emitting layer, and a resonant distance of the light emitting element OL may be controlled by providing the auxiliary light emitting layer. In addition, as the auxiliary light emitting layer is provided, a color purity of the light emitted from the light emitting layer EML may be improved.

The second electrode CE may be located on the light emitting layer EML. The second electrode CE may be commonly arranged over the pixels PX (refer to FIG. 4) to receive a common voltage. The second electrode CE may extend from the second area A2 and may be arranged to overlap at least a portion of the dam area A1-D, however, it should not be limited thereto or thereby. The common layer may extend from the second area A2 to the margin area A1-M via the dam area A1-D, and the present disclosure should not be particularly limited.

Each of the first electrode AE and the second electrode CE may be a transmissive electrode, a transflective electrode, or a reflective electrode. The transmissive electrode may include a transparent metal oxide, e.g., indium tin oxide (ITO), indium zinc oxide (IZO), zinc oxide (ZnO), indium tin zinc oxide (ITZO), etc. The transflective electrode or the reflective electrode may include Ag, Mg, Cu, Al, Pt, Pd, Au, Ni, Nd, Ir, Cr, Li, Ca, LiF/Ca (a stack structure of LiF and Ca), LiF/Al (a stack structure of LiF and Al), Mo, Ti, Yb, W, a compound thereof, or a mixture thereof, e.g., AgMg, AgYb, or MgYb, or materials having a stacked structure LiF and Ca or a stacked structure LiF and Al.

Each of the first electrode AE and the second electrode CE may have a multi-layer structure of a reflective layer or a semi-transmissive layer, which is formed of the above-mentioned material, and a transparent conductive layer formed of indium tin oxide (ITO), indium zinc oxide (IZO), zinc oxide (ZnO), or indium tin zinc oxide (ITZO). As an example, the first electrode AE and the second electrode CE having the multi-layer structure may have a three-layer structure of ITO/Ag/ITO, however, it should not be limited thereto or thereby.

The encapsulation layer TFE may be located on the light emitting element OL and may cover (encapsulate) the light emitting element OL. The encapsulation layer TFE may include at least one insulating layer. The encapsulation layer TFE may include first and second inorganic layers IOL1 and IOL2 and at least one organic layer MN located between the first and second inorganic layers IOL1 and IOL2. The first inorganic layer IOL1 may be located on the second electrode CE. The organic layer MN and the second inorganic layer IOL2 may be sequentially arranged on the first inorganic layer IOL1.

The first inorganic layer IOL1 and the second inorganic layer IOL2 may protect the light emitting element OL from moisture and/or oxygen. The first inorganic layer IOL1 and the second inorganic layer IOL2 may include at least one of aluminium oxide, titanium oxide, silicon oxide, silicon nitride, silicon oxynitride, zirconium oxide, or hafnium oxide. However, materials for the first inorganic layer IOL1 and the second inorganic layer IOL2 should not be limited thereto or thereby.

The organic layer MN may protect the light emitting element OL from a foreign substance such as dust particles. The organic layer MN may include an acrylic-based resin. However, it should not be limited thereto or thereby.

The organic layer MN may have a thickness equal to or greater than about 5 µm and equal to or smaller than about 10 µm. According to the present disclosure, since a cover layer PVX including an organic material is located in the second area A2 and the dam area A1-D, a thickness of the organic layer MN may decrease. Accordingly, a waviness of the display module 100 may be improved. The waviness of the display module 100 will be described in more detail later.

According to some embodiments, the display module 100 may include the cover layer PVX. According to some embodiments, the cover layer PVX may be located directly on the second inorganic layer IOL2. The cover layer PVX may overlap the second area A2 and the dam area A1-D and may be spaced apart from the margin area A1-M. The cover layer PVX may include the organic material.

The cover layer PVX may be formed on the encapsulation layer TFE by a photoresist process. The cover layer PVX may provide a flat surface for components located thereon. According to the present disclosure, the cover layer PVX overlapping the second area A2 may have a thickness equal to or greater than about 2 µm and equal to or smaller than about 5 µm. A portion of the cover layer PVX overlapping the first area A1 has a greater thickness than that of a portion of the cover layer PVX overlapping the second area A2.

According to the present disclosure, the cover layer PVX may be spaced apart from the margin area A1-M and the hole area A1-H, and thus, a process of removing the organic layer overlapping the hole area A1-H and providing a flat surface, e.g., a pre-ablation process performed before a laser beam is irradiated onto the base layer SUB may be omitted in the process of forming the module hole MH. This will be described in detail later.

An anti-reflective layer ARL may be located on the cover layer PVX. The anti-reflective layer ARL may be located between the cover layer PVX and the window 300. The anti-reflective layer ARL may reduce reflection of an external light incident thereto from the outside of the electronic device 1000. That is, the anti-reflective layer ARL may reduce a reflectance of the electronic device 1000 with respect to the external light. The anti-reflective layer ARL may include a polarizer, a retarder, a destructive interference structure, or a plurality of color filters.

A first adhesive layer AD1 may be located between the anti-reflective layer ARL and the cover layer PVX and may attach the anti-reflective layer ARL to the cover layer PVX. The first adhesive layer AD1 may include at least one of an optically clear adhesive, an optically clear adhesive resin, or a pressure sensitive adhesive (PSA).

The window 300 may be located on the anti-reflective layer ARL. A second adhesive layer AD2 may be located between the anti-reflective layer ARL and the window 300 and may attach the anti-reflective layer ARL to the window 300. The second adhesive layer AD2 may include the same material as that of the first adhesive layer AD1.

The window 300 may further include a bezel pattern CBM located on a rear surface of the window 300. The bezel pattern CBM may be printed or colored on the rear surface of the window 300 or may be attached to rear surface of the window 300 by a separate adhesive layer.

The bezel pattern CBM may be located in the first area A1 and may be provided with an opening defined therethrough to correspond to the module hole MH. The bezel pattern CBM may prevent unnecessary external light from being incident into the electronic module 400, and thus, a performance of the electronic module 400 may be improved. In addition, the bezel pattern CBM may prevent components located in the first area A1 from being perceived by the user. The bezel pattern CBM may include a material that blocks the light, and the material for the bezel pattern CBM should not be particularly limited.

The module hole MH may be defined through the display module 100. The module hole MH may correspond to the hole area A1-H of the first area A1. According to the present disclosure, the position, number, and shape of the module hole MH defined in the display module 100 may correspond to the position, number, and shape of the electronic modules 400 located under the base layer SUB. The electronic module 400 may overlap the module hole MH. According to the present disclosure, as the electronic module 400 is arranged to overlap the active area AA (refer to FIG. 2), a separate space required to arrange the electronic module 400 in the peripheral area NAA (refer to FIG. 2) may be omitted. Accordingly, the peripheral area NAA (refer to FIG. 2) of the display module 100 may be reduced.

The module hole MH may be formed through the base layer SUB, the circuit element layer, the display element layer, and the encapsulation layer TFE, which overlap the hole area A1-H of the first area A1 of the display panel 110. The filling portion described with reference to FIG. 4 may be a polymer resin filled in an inner space that is formed through the circuit element layer, the display element layer, and the encapsulation layer TFE except the base layer SUB between the base layer SUB and the window 300 in the process of forming the module hole MH.

According to some embodiments, at least a portion of the bezel pattern CBM may be exposed without being covered by the first adhesive layer AD1, the second adhesive layer AD2, and the anti-reflective layer ARL, and an opening may be defined through the first adhesive layer AD1, the second adhesive layer AD2, and the anti-reflective layer ARL to correspond to the opening defined through the bezel pattern CBM. A portion of the second adhesive layer AD2 may cover a portion of the bezel pattern CBM.

The circuit element layer of the display panel 110 may further include a dam pattern DMP located in the dam area A1-D of the first area A1. The dam pattern DMP may be located between the module hole MH and the second area A2 and may surround the module hole MH. The dam pattern DMP may be provided in plural, and the dam patterns DMP may have different widths and different heights from each other.

As an example, the dam pattern DMP may include first, second, third, and fourth portions DM1, DM2, DM3, and DM4 sequentially stacked. Each of the first, second, third, and fourth portions DM1, DM2, DM3, and DM4 may include an organic material. As an example, at least one of the first, second, third, or fourth portions DM1, DM2, DM3, and DM4 may include the same material as the insulating layer including the organic material among the first, second, third, and fourth insulating layers 10, 20, 30, and 40.

According to some embodiments, in at least one dam pattern DMP, one of the first, second, third, and fourth portions DM1, DM2, DM3, and DM4 may be omitted, and thus, the at least one dam pattern DMP may have a two-layer or three-layer structure. However, it should not be particularly limited.

A portion of the dam pattern DMP may be covered by the second electrode CE. The other portion of the dam pattern DMP may be covered by the first inorganic layer IOL1 of the encapsulation layer TFE. The dam pattern DMP may define a boundary of the organic layer MN in the dam area A1-D. Accordingly, the organic layer MN may be arranged along the dam pattern DMP to surround the module hole MH. At least one of the dam patterns DMP may include protruding patterns U-1 and U-2 and lower patterns B-1 and B-2.

A lower opening 30-OP may be defined between the first portions DM1 adjacent to each other to expose the second insulating layer 20, and an upper opening 40-OP may be defined between the second portions DM2 adjacent to each other to correspond to the lower opening 30-OP and to expose the second insulating layer 20. In the present disclosure, the lower opening 30-OP and the upper opening 40-OP, which overlap each other, may be defined as one tip opening.

Each of the protruding patterns U-1 and U-2 may include one side U-E and the other side U-C. The one side U-E of a first protruding pattern U-1 may protrude between a side surface of the first portion DM1 and a side surface of the second portion DM2 of the dam pattern DMP defining the tip opening, and the other side U-C of the first protruding pattern U-1 may be located between the first portion DM1 and the second portion DM2. The one side U-E of the first protruding pattern U-1 protruded between the side surface of the first portion DM1 and the side surface of the second portion DM2 may be covered by the first inorganic layer IOL1.

A portion of the first protruding pattern U-1, which is located between the first portion DM1 and the second portion DM2, may be connected to a corresponding first lower pattern B-1 via a contact hole 30-H defined through the first portion DM1.

The one side U-E of a second protruding pattern U-2 may protrude between the side surface of the first portion DM1 and the side surface of the second portion DM2, which define the tip opening, and the other side U-C of the second protruding pattern U-2 may be located between the first portion DM1 and the second portion DM2. The one side U-E of the second protruding pattern U-2 protruded between the side surface of the first portion DM1 and the side surface of the second portion DM2 may be covered by the first inorganic layer IOL1.

A portion of the second protruding pattern U-2, which is located between the first portion DM1 and the second portion DM2, may be connected to a corresponding second lower pattern B-2 via the contact hole 30-H defined through the first portion DM1.

The circuit element layer may include the tip portion TIP. One tip portion TIP may be defined by the lower opening 30-OP, the upper opening 40-OP, and one sides U-E each protruding from a corresponding tip opening of different protruding patterns U-1 and U-2. The one sides U-E respectively included in the different protruding patterns U-1 and U-2 of the tip portion TIP may face each other.

The circuit element layer may further include a half tip portion TIPa. The half tip portion TIPa may be defined by only one of the one sides U-E of the protruding patterns U-1 and U-2 protruding from a corresponding tip opening. FIG. 5 shows two tip portions TIP and two half tip portions TIPa as a representative example, however, the number of the tip portions TIP and the number of the half tip portions TIPa should not be particularly limited, and the half tip portion TIPa may be omitted.

The tip portions TIP and the half tip portions TIPa may surround the module hole MH and may have a closed-line shape when viewed in the plane. The tip portion TIP described with reference to FIG. 4 may correspond to one of the tip portion TIP and the half tip portion TIPa described with reference to FIG. 5.

Floating patterns C-P may be located in corresponding tip openings, respectively. The floating patterns C-P may include the same material as the common layer. As an example, the floating patterns C-P may include the same material as at least one of the second electrode CE, the hole control layer, or the electron control layer. The floating patterns C-P may correspond to portions of the common layer disconnected due to the tip portions TIP and the half tip portions TIPa in a process of forming the common layer over the active area AA.

According to the present disclosure, as the floating patterns C-P including the same material as the common layer are disconnected by the tip portions TIP and the half tip portions TIPa, the path through which moisture and/or oxygen enters from the module hole MH into the light emitting element OL may be blocked. Accordingly, even though the module hole MH is defined in the active area AA, the display quality of the display panel 110 may be improved.

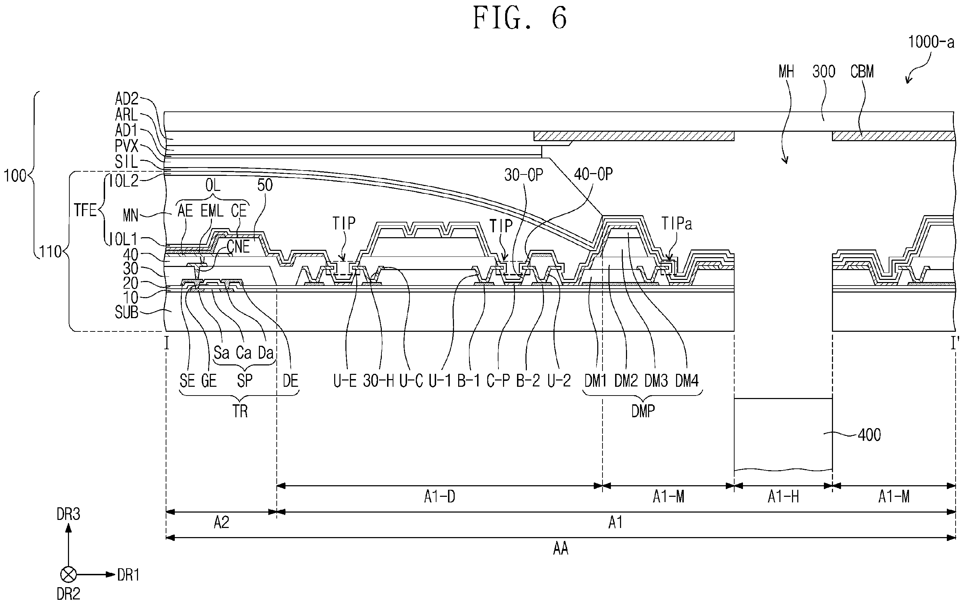

FIG. 6 is a cross-sectional view showing a display module 100 according to some embodiments of the present disclosure. In FIG. 6, the same/similar reference numerals denote the same/similar elements in FIGS. 1 to 5, and thus, detailed descriptions of the same/similar elements will be omitted.

An electronic device 1000-a may include the display module 100, a housing 200 (refer to FIG. 2), a window 300, and an electronic module 400. Hereinafter, descriptions will focus on differences between the display module 100 described with reference to FIG. 5 and the display module 100 of FIG. 6.

The display module 100 may include a display panel 110, an intermediate layer SIL, a cover layer PVX, a first adhesive layer AD1, an anti-reflective layer ARL, and a second adhesive layer AD2.

The display panel 110 may include a circuit element layer including a base layer SUB, a transistor TR, and insulating layers 10, 20, 30, and 40, a display element layer including a pixel definition layer 50 and a light emitting element OL, and an encapsulation layer TFE.

The intermediate layer SIL may be located on the display panel 110. As an example, the intermediate layer SIL may be located on a second inorganic layer IOL2. The intermediate layer SIL may be located in a second area A2 and an area of a first area A1 except a hole area A1-H.

The intermediate layer SIL may include an inorganic material. As an example, the intermediate layer SIL may include at least one of aluminium oxide, titanium oxide, silicon oxide, silicon nitride, silicon oxynitride, zirconium oxide, or hafnium oxide.

According to some embodiments, the cover layer PVX may be located directly on the intermediate layer SIL. The cover layer PVX may overlap the second area A2 and a dam area A1-D and may be spaced apart from a margin area A1-M. The cover layer PVX may include an organic material. The cover layer PVX may be formed on the intermediate layer SIL through a photoresist process. The cover layer PVX may provide a flat surface for components located thereon.

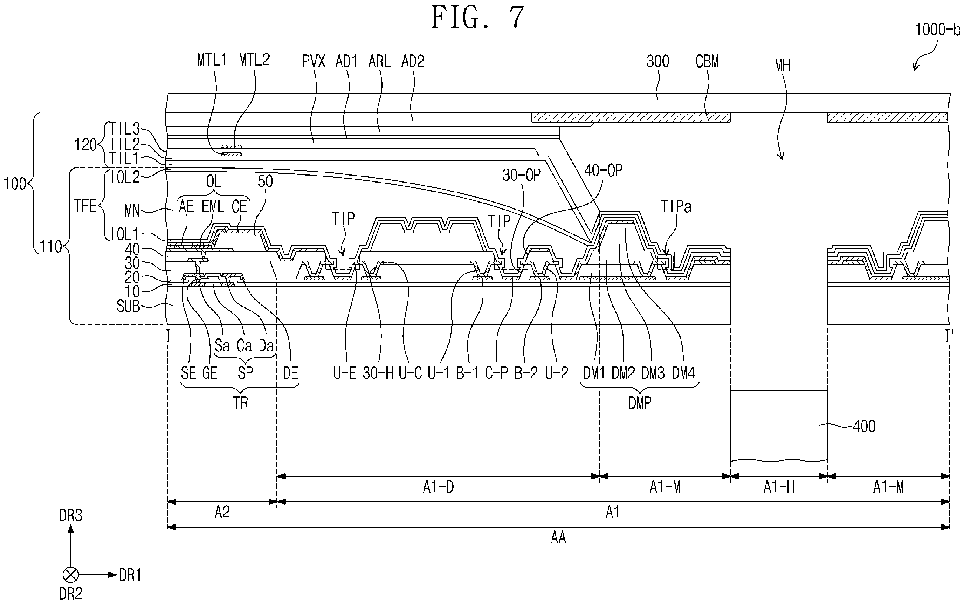

FIG. 7 is a cross-sectional view showing a display module 100 according to some embodiments of the present disclosure. In FIG. 7, the same/similar reference numerals denote the same/similar elements in FIGS. 1 to 5, and thus, detailed descriptions of the same/similar elements will be omitted.

An electronic device 1000-b may include the display module 100, a housing 200 (refer to FIG. 2), a window 300, and an electronic module 400. Hereinafter, descriptions will focus on differences between the display module 100 described with reference to FIG. 5 and the display module 100 of FIG. 7.

The display module 100 may include a display panel 110, an input sensor 120, a cover layer PVX, a first adhesive layer AD1, an anti-reflective layer ARL, and a second adhesive layer AD2.

The display panel 110 may include a circuit element layer including a base layer SUB, a transistor TR, and insulating layers 10, 20, 30, and 40, a display element layer including a pixel definition layer 50 and a light emitting element OL, and an encapsulation layer TFE. According to some embodiments, the input sensor 120 may correspond to the input sensor 120 described with reference to FIG. 3.

The input sensor 120 may sense the user input TC (refer to FIG. 1) applied thereto from the outside. The user input TC (refer to FIG. 1) may include various types of external inputs, such as a part of the user's body, light, heat, pen, or pressure.

The input sensor 120 may be located on the display panel 110. As an example, the input sensor 120 may be directly formed on the encapsulation layer TFE. The input sensor 120 may include conductive patterns MTL1 and MTL2 and sensing insulating layers TIL1, TIL2, and TIL3. The sensing insulating layers TIL1, TIL2, and TIL3 may include a first sensing insulating layer TIL1, a second sensing insulating layer TIL2, and a third sensing insulating layer TIL3. The conductive patterns MTL1 and MTL2 may overlap the pixel definition layer 50 and may be spaced apart from an opening defined through the pixel definition layer 50.

The first sensing insulating layer TIL1 may be located directly on the encapsulation layer TFE. The second sensing insulating layer TIL2 may be located on the first sensing insulating layer TIL1. First conductive patterns MTL1 may be located on the second sensing insulating layer TIL2 and may be covered by the third sensing insulating layer TIL3.

Second conductive patterns MTL2 may be located on the third sensing insulating layer TIL3. According to some embodiments, the second conductive patterns MTL2 included in the input sensor 120 may be covered by the cover layer PVX.

Each of the conductive patterns MTL1 and MTL2 may have a conductivity. Each of the conductive patterns MTL1 and MTL2 may have a single-layer or multi-layer structure, and it should not be particularly limited. At least one conductive pattern of the conductive patterns MTL1 and MTL2 may be provided in the form of mesh lines when viewed in the plane.

The mesh lines forming the conductive patterns MTL1 and MTL2 may overlap the pixel definition layer 50 and may be spaced apart from a light emitting layer EML. Accordingly, although the input sensor 120 is directly formed on the display panel 110, a light generated by the pixels PXij (refer to FIG. 2) of the display panel 110 may be provided to the user without being interfered by the input sensor 120.

The cover layer PVX may be located on the third sensing insulating layer TIL3 and may cover the second conductive patterns MTL2. The cover layer PVX may compensate for a step difference occurring in the display panel 110. Accordingly, a flat surface may be provided on components located on the display panel 110. The cover layer PVX may include an organic material.

According to some embodiments, the first sensing insulating layer TIL1 and the third sensing insulating layer TIL3 may overlap a second area A2 and a dam area A1-D and may be spaced apart from a margin area A1-M. The first sensing insulating layer TIL1 and the third sensing insulating layer TIL3 may include an organic material.

According to some embodiments, the first sensing insulating layer TIL1 and the third sensing insulating layer TIL3 in the second area A2 may have a thickness greater than a thickness of the cover layer PVX in the second area A2.

The second sensing insulating layer TIL2 may extend from the second area A2 to the margin area A1-M via the dam area A1-D. Accordingly, one end of the second sensing insulating layer TIL2, which is adjacent to a boundary between the margin area A1-M and a hole area A1-H, may be exposed to the outside through a module hole MH. The second sensing insulating layer TIL2 may include an inorganic material.

According to some embodiments, the first sensing insulating layer TIL1, the third sensing insulating layer TIL3, and the cover layer PVX may be formed through a photoresist process. Accordingly, the first sensing insulating layer TIL1, the third sensing insulating layer TIL3, and the cover layer PVX may overlap the second area A2 and the dam area A1-D and may be spaced apart from the margin area A1-M. Accordingly, a path through which moisture/oxygen entering from the module hole MH moves along the first sensing insulating layer TIL1, the third sensing insulating layer TIL3, and the cover layer PVX, which include the organic material, may be blocked. Thus, a display quality of the electronic device 1000-b may be improved.

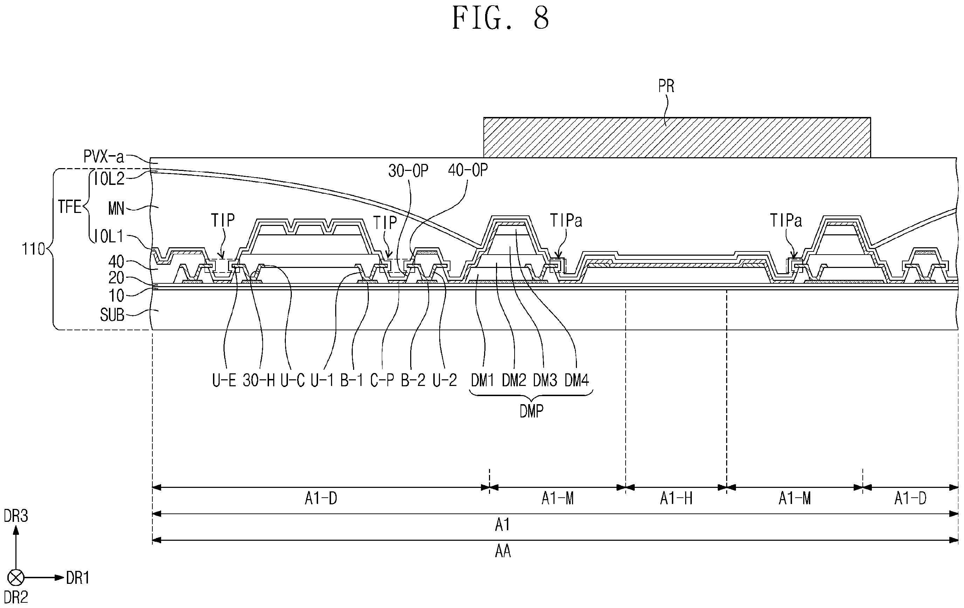

FIGS. 8 to 12 are cross-sectional views illustrating a method of manufacturing an electronic device according to some embodiments of the present disclosure. FIGS. 8 to 12 show processes of manufacturing the electronic device 1000 described with reference to FIG. 5. In FIGS. 8 to 12, the same/similar reference numerals denote the same/similar elements in FIGS. 1 to 5, and thus, details thereof will be omitted.

Referring to FIG. 8, the manufacturing method of the electronic device may include providing the display panel 110. The display panel 110 may be provided in a state in which the circuit element layer including the base layer SUB, the transistor TR, and the insulating layers 10, 20, 30, and 40, the display element layer including the pixel definition layer 50 and the light emitting element OL, and the encapsulation layer TFE are formed.

The base layer SUB may include the first area A1 and the second area A2 (refer to FIG. 2) surrounding the first area A1. The first area A1 may include the dam area A1-D, the margin area A1-M, and a hole processing area A1-H. The dam area A1-D may be defined adjacent to the second area A2 (refer to FIG. 2). The margin area A1-M may be located between the dam area A1-D and the hole processing area A1-H.

The encapsulation layer TFE may include the first and second inorganic layers IOL1 and IOL2 and at least one organic layer MN located between the first and second inorganic layers IOL1 and IOL2. The first and second inorganic layers IOL1 and IOL2 may be in contact with each other in the margin area A1-M.

Then, the manufacturing method of the electronic device may include forming an initial cover layer PVX-a (referred to as a cover layer in claims) on the display panel 110. The initial cover layer PVX-a may be formed by entirely coating the organic material over the first area A1 and the second area A2.

After that, the manufacturing method of the electronic device may include patterning the initial cover layer PVX-a. The initial cover layer PVX-a may be patterned through the photoresist process. Accordingly, the photoresist process may be carried out after a photomask PR is located above the initial cover layer PVX-a to overlap the margin area A1-M and the hole processing area A1-H.

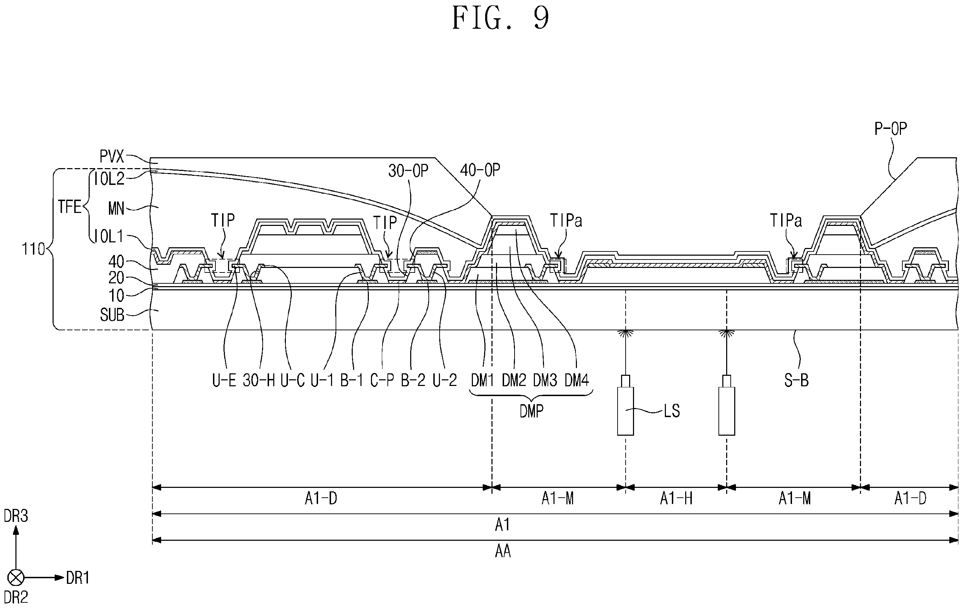

Referring to FIG. 9, the initial cover layer PVX-a may be patterned to form the cover layer PVX through which an opening P-OP is defined. The opening P-OP may be formed by removing the initial cover layer PVX-a overlapping the margin area A1-M and the hole processing area A1-H through the photoresist process. Therefore, the second inorganic layer IOL2 overlapping the margin area A1-M and the hole processing area A1-H may be exposed through the opening P-OP.

Then, the manufacturing method of the electronic device may include irradiating a laser beam onto a rear surface S-B of the base layer SUB. The laser beam may be irradiated onto the rear surface S-B of the base layer SUB along a boundary between the margin area A1-M and the hole processing area A1-H using a laser unit LS located above the rear surface S-B of the base layer SUB. This may be a preliminary work to form the module hole MH (refer to FIG. 5) in the display panel 110.

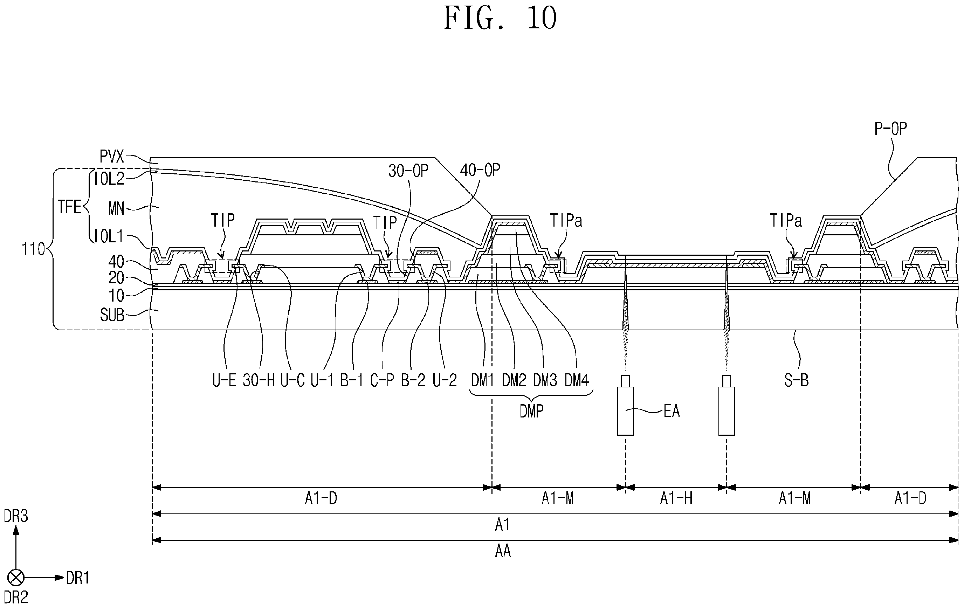

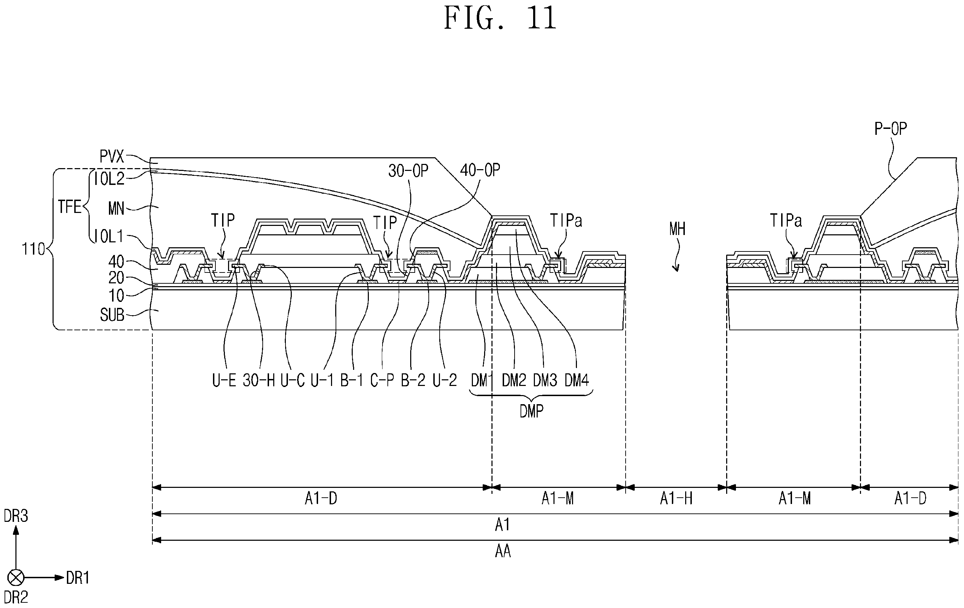

Referring to FIGS. 10 and 11, the manufacturing method of the electronic device may include forming the module hole MH. After the irradiating of the laser beam, an etchant may be sprayed to the area where the laser beam is irradiated to form the module hole MH. The etchant may be sprayed to the area where the laser beam is irradiated while a spray unit EA located above the rear surface S-B of the base layer SUB moves along the area where the laser beam is irradiated.

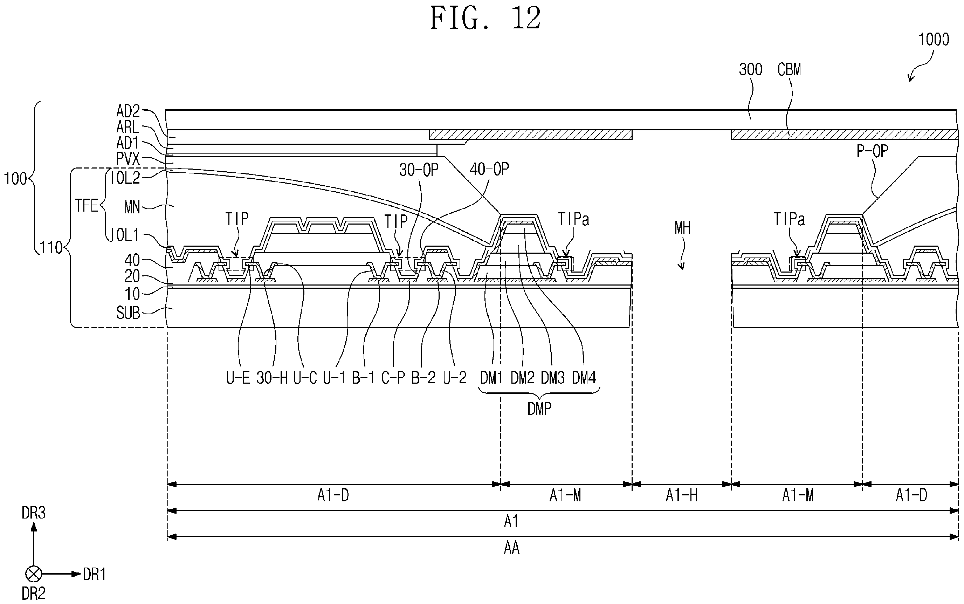

Referring to FIG. 12, the manufacturing method of the electronic device may further include coupling the anti-reflective layer ARL. The anti-reflective layer ARL may be coupled with the cover layer PVX by the first adhesive layer AD1. The opening may be defined through the first adhesive layer AD1 and the anti-reflective layer ARL to overlap the opening P-OP.

Then, the manufacturing method of the electronic device may further include coupling the window 300. The window 300 may be coupled with the anti-reflective layer ARL by the second adhesive layer AD2. The bezel pattern CBM may be formed on the rear surface of the window 300 overlapping the first area A1. The bezel pattern CBM may be provided with the opening defined therethrough and overlapping the module hole MH. The second adhesive layer AD2 may be provided with the opening defined therethrough and overlapping the opening P-OP, and the bezel pattern CBM may be exposed through the opening defined through the first adhesive layer AD1, the anti-reflective layer ARL, and the second adhesive layer AD2.

According to the present disclosure, as the thickness of the organic layer MN may be limited to a range from about 5 µm or more to about 10 µm or less in the second area A2 (refer to FIG. 5), the waviness generated when the thickness of the organic layer MN is varied in the dam area A1-D may be improved. In addition, the electronic device 1000 (refer to FIG. 5) may include the cover layer PVX located only in the second area A2 (refer to FIG. 2) and the dam area A1-D and spaced apart from the margin area A1-M and the hole processing area A1-H, and thus, the pre-ablation process required to remove the organic layer formed by the inkjet process may be omitted in the process of forming the module hole MH. Accordingly, a manufacturing cost in the manufacturing method of the electronic device may be reduced.

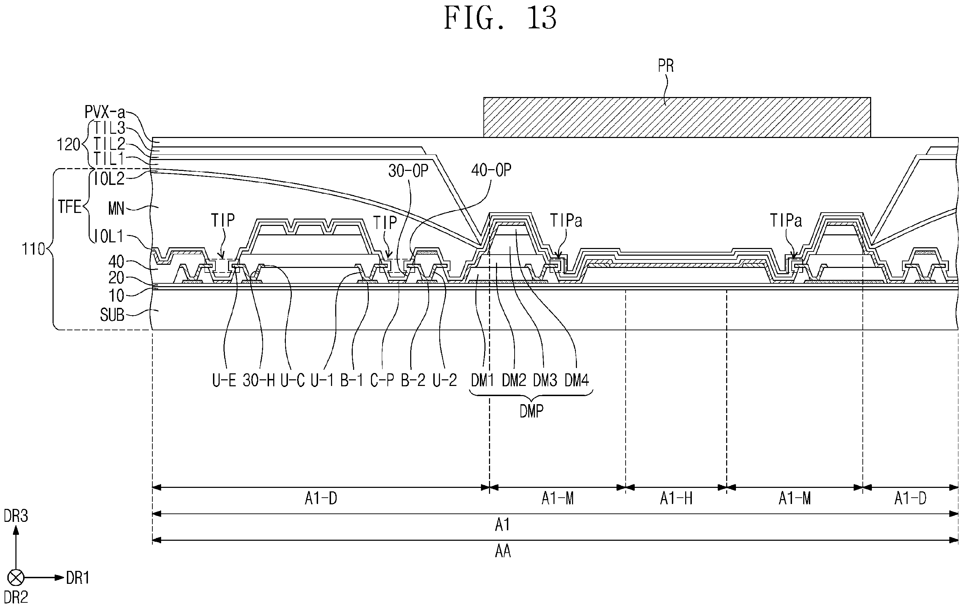

FIGS. 13 to 17 are cross-sectional views illustrating a method of manufacturing an electronic device according to some embodiments of the present disclosure. FIGS. 13 to 17 show processes of manufacturing the electronic device 1000-b described with reference to FIG. 7. In FIGS. 13 to 17, the same/similar reference numerals denote the same/similar elements in FIGS. 1 to 12, and thus, details thereof will be omitted.

Referring to FIG. 13, the manufacturing method of the electronic device may include providing the display panel 110. The display panel 110 may be provided in a state in which the circuit element layer including the base layer SUB, the transistor TR, and the insulating layers 10, 20, 30, and 40, the display element layer including the pixel definition layer 50 and the light emitting element OL, and the encapsulation layer TFE are formed.

The base layer SUB may include the first area A1 and the second area A2 (refer to FIG. 2) surrounding the first area A1. The first area A1 may include the dam area A1-D, the margin area A1-M, and a hole processing area A1-H. The dam area A1-D may be defined adjacent to the second area A2 (refer to FIG. 2). The margin area A1-M may be located between the dam area A1-D and the hole processing area A1-H.

Then, the manufacturing method of the electronic device 1000-b may further include forming the input sensor 120. The input sensor 120 may be formed on the display panel 110 through successive processes. Accordingly, the first sensing insulating layer TIL1 may be directly formed on the second inorganic layer IOL2. The first sensing insulating layer TIL1 may be formed by entirely coating the organic material over the first area A1 and the second area A2 (refer to FIG. 2) and patterning the organic material using the photoresist process.

The forming of the input sensor 120 may include forming the second sensing insulating layer TIL2 on the first sensing insulating layer TIL1. The second sensing insulating layer TIL2 may be formed by entirely coating the inorganic material over the first area A1 and the second area A2 (refer to FIG. 2) and patterning the inorganic material using the photoresist process.

After that, the manufacturing method of the electronic device 1000-b may include forming the first conductive patterns MTL1 (refer to FIG. 7) on the second sensing insulating layer TIL2. The first conductive patterns MTL1 (refer to FIG. 7) may be formed by coating a material including a metal material on the second sensing insulating layer TIL2 and patterning portions of the material, which overlap the pixel definition layer 50 (refer to FIG. 7).

The manufacturing method of the electronic device 1000-b may include forming the third sensing insulating layer TIL3 on the second sensing insulating layer TIL2. The third sensing insulating layer TIL3 may be formed by entirely coating an organic material over the first area A1 and the second area A2 (refer to FIG. 2) and patterning the organic material through a photoresist process.

The manufacturing method of the electronic device 1000-b may include forming the second conductive patterns MTL2 (refer to FIG. 7) on the third sensing insulating layer TIL3. The second conductive patterns MTL2 (refer to FIG. 7) may be formed by coating a material including a transparent metal oxide material on the third sensing insulating layer TIL3 and patterning portions of the transparent metal oxide material, which overlap the pixel definition layer 50 (refer to FIG. 7). The second conductive patterns MTL2 (refer to FIG. 7) may have a lattice shape or a mesh shape when viewed in the plane.

The manufacturing method of the electronic device 1000-b may include forming an initial cover layer PVX-a (referred to as a cover layer in claims) on the input sensor 120. The initial cover layer PVX-a may be formed by entirely coating the organic material over the first area A1 and the second area A2.

The manufacturing method of the electronic device 1000-b may include patterning the initial cover layer PVX-a. The initial cover layer PVX-a may be patterned through a photoresist process. Accordingly, the photoresist process may be carried out after the photomask PR is located above the initial cover layer PVX-a to overlap the margin area A1-M and the hole processing area A1-H.

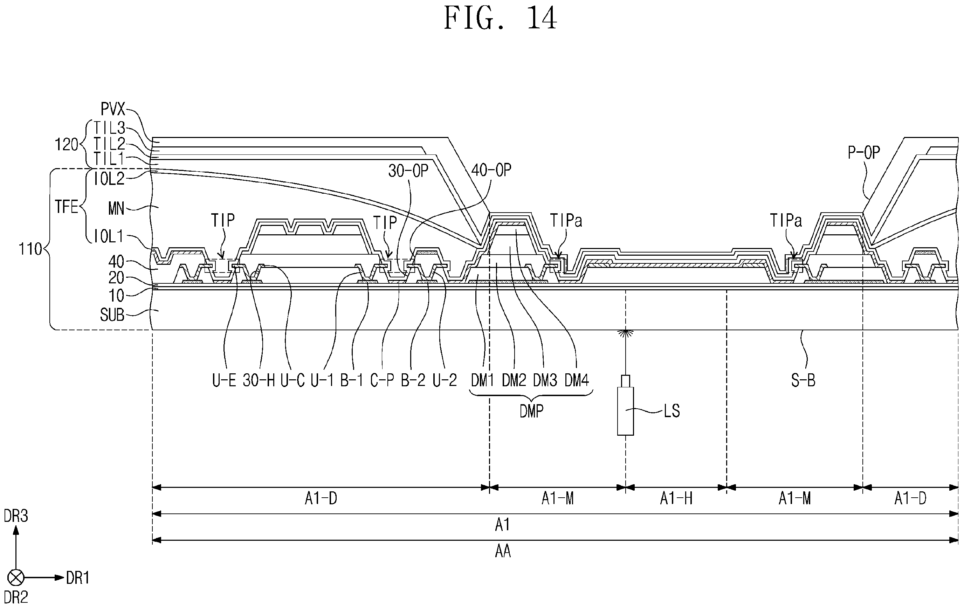

Referring to FIG. 14, according to the manufacturing method of the electronic device 1000-b, the initial cover layer PVX-a may be patterned, and thus, the cover layer PVX through which the opening P-OP is defined may be formed. The opening P-OP may be formed by removing the initial cover layer PVX-a overlapping the margin area A1-M and the hole processing area A1-H through the photoresist process. Thus, the second inorganic layer IOL2 overlapping the margin area A1-M and the hole processing area A1-H may be exposed through the opening P-OP.

The manufacturing method of the electronic device 1000-b may include irradiating a laser beam onto a rear surface S-B of the base layer SUB. The laser beam may be irradiated onto the rear surface S-B of the base layer SUB along a boundary between the margin area A1-M and the hole processing area A1-H using a laser unit LS located above the rear surface S-B of the base layer SUB. This may be a preliminary work to form the module hole MH (refer to FIG. 7) in the display panel 110.

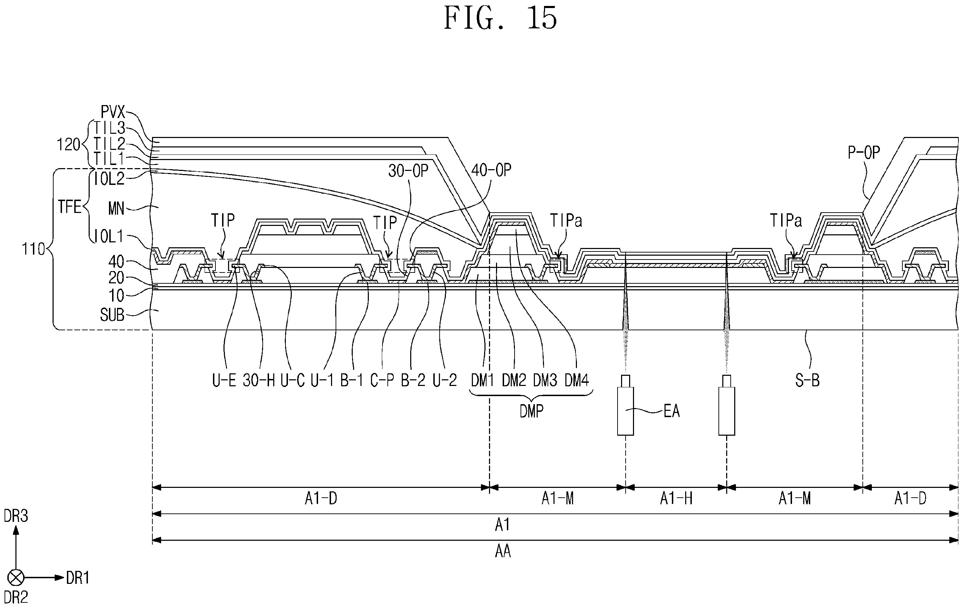

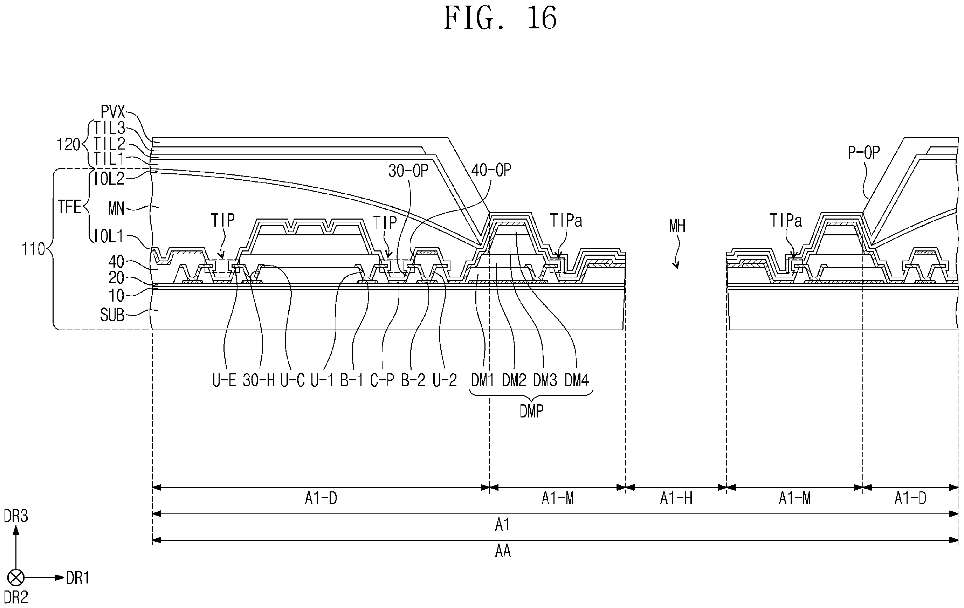

Referring to FIGS. 15 and 16, the manufacturing method of the electronic device 1000-b may include forming the module hole MH. After the irradiating of the laser beam, an etchant may be sprayed to the area where the laser beam is irradiated to form the module hole MH. The etchant may be sprayed to the area where the laser beam is irradiated while a spray unit EA located above the rear surface S-B of the base layer SUB moves along the area where the laser beam is irradiated.

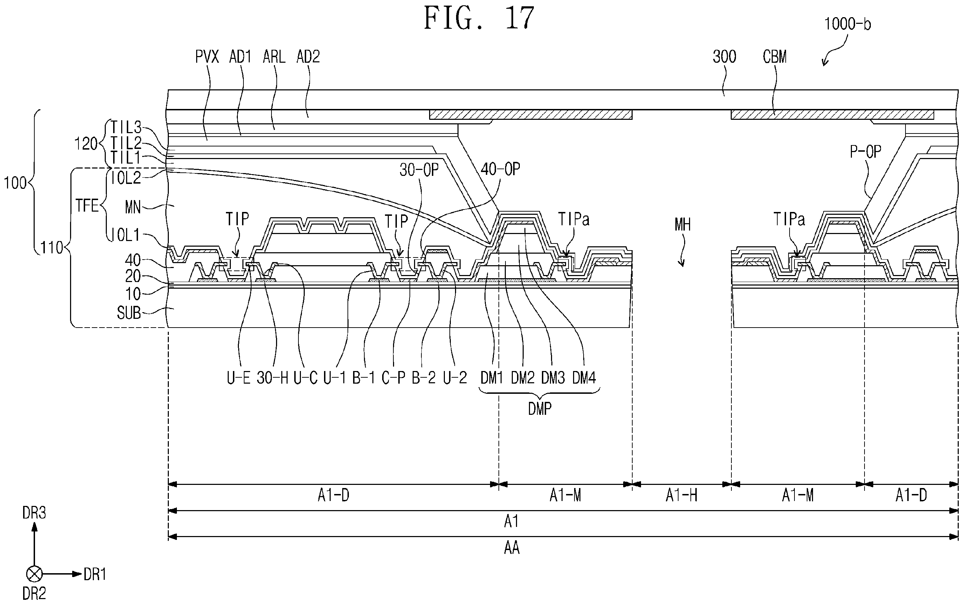

Referring to FIG. 17, the manufacturing method of the electronic device 1000-b may further include coupling the anti-reflective layer ARL. The anti-reflective layer ARL may be coupled with the cover layer PVX by the first adhesive layer AD1. The opening may be defined through the first adhesive layer AD1 and the anti-reflective layer ARL to overlap the opening P-OP.

Then, the manufacturing method of the electronic device 1000-b may further include coupling the window 300. The window 300 may be coupled with the anti-reflective layer ARL by the second adhesive layer AD2. The bezel pattern CBM may be formed on the rear surface of the window 300 overlapping the first area A1. The bezel pattern CBM may be provided with the opening defined therethrough and overlapping the module hole MH. The second adhesive layer AD2 may be provided with the opening defined therethrough and overlapping the opening P-OP, and the bezel pattern CBM may be exposed through the opening defined through the first adhesive layer AD1, the anti-reflective layer ARL, and the second adhesive layer AD2.

Although the embodiments of the present disclosure have been described, it is understood that the present disclosure should not be limited to these embodiments but various changes and modifications can be made by one ordinary skilled in the art within the scope of the present disclosure as hereinafter claimed.

Therefore, the disclosed subject matter should not be limited to any single embodiment described herein, and the scope of the present inventive concept shall be determined according to the attached claims, and their equivalents.

## Claims

1. An electronic device comprising:
a display panel comprising a base layer comprising a first area and a second area surrounding the first area, pixels on the base layer overlapping the second area, and an encapsulation layer covering the pixels and provided with a module hole defined therethrough and overlapping the first area;
a cover layer comprising an organic material and on the display panel;
an anti-reflective layer on the cover layer;
an electronic module overlapping the module hole; and
a window on the anti-reflective layer,
wherein the first area comprises a dam area adjacent to the second area and surrounding the module hole and a margin area between the module hole and the dam area, and the cover layer overlaps the dam area and the second area and is spaced apart from the margin area.

2. The electronic device of claim 1, wherein the cover layer overlapping the second area has a thickness equal to or greater than 2 micrometers and equal to or smaller than 5 micrometers.

3. The electronic device of claim 1 or claim 2, wherein the cover layer overlapping the first area has a thickness greater than a thickness of the cover layer overlapping the second area.

4. The electronic device of any one of claims 1 to 3, wherein the encapsulation layer comprises:
a first inorganic layer covering the pixels;
a second inorganic layer on the first inorganic layer; and
an organic layer between the first inorganic layer and the second inorganic layer.

5. The electronic device of claim 4, wherein:
(i) the cover layer contacts the second inorganic layer; and/or
(ii) the first inorganic layer and the second inorganic layer contact each other in the margin area.

6. The electronic device of claim 4, wherein the display panel further comprises an intermediate layer between the second inorganic layer and the cover layer and extending from the second area to the margin area via the dam area, and the intermediate layer comprises an inorganic material.

7. The electronic device of any one of claims 4 to 6, wherein the organic layer overlapping the second area has a thickness equal to or greater than 5 micrometers and equal to or smaller than 10 micrometers.

8. The electronic device of claim 4, further comprising an input sensor comprising:
a first sensing insulating layer on the encapsulation layer;
a second sensing insulating layer on the first sensing insulating layer;
a first conductive layer on the second sensing insulating layer;
a third sensing insulating layer covering the first conductive layer and on the second sensing insulating layer; and
a second conductive layer on the third sensing insulating layer, wherein the cover layer covers the second conductive layer and is on the third sensing insulating layer.

9. The electronic device of claim 8, wherein the first sensing insulating layer and the third sensing insulating layer overlap the second area and the dam area and are spaced apart from the margin area, and the second sensing insulating layer extends from the second area to the margin area via the dam area.

10. The electronic device of claim 9, wherein the first sensing insulating layer and the third sensing insulating layer have a thickness greater than a thickness of the cover layer, optionally wherein the first sensing insulating layer and the third sensing insulating layer comprise an organic material, and the second sensing insulating layer comprises an inorganic material.

11. The electronic device of any one of claims 4 to 10, further comprising dam patterns in the dam area and surrounding the module hole, wherein each of the dam patterns comprises a tip portion protruding from a side surface of the dam pattern and comprising a conductive material.

12. The electronic device of claim 11, wherein:
(i) the tip portion is covered by the first inorganic layer; and/or
(ii) a boundary of the organic layer in the dam area is defined by one of the dam patterns.

13. The electronic device of any one of claims 1 to 12, wherein:
(i) the electronic device further comprises:
a first adhesive layer between the cover layer and the anti-reflective layer; and
a second adhesive layer between the anti-reflective layer and the window, wherein the first and second adhesive layers comprise at least one of an optically clear adhesive, an optically clear adhesive resin, or a pressure sensitive adhesive; and/or
(ii) the window further comprises a bezel pattern on a rear surface of the window overlapping the first area and provided with an opening defined therethrough and overlapping the module hole.

14. A method of manufacturing an electronic device, comprising:
providing a display panel comprising a base layer in which a first area comprising a hole processing area, a margin area surrounding the hole processing area, and a dam area surrounding the margin area is defined, a pixel formed on the base layer, and an encapsulation layer covering the pixel;
coating an organic material on the display panel to form a cover layer;
patterning the cover layer overlapping the hole processing area and the margin area;
irradiating a laser beam on a rear surface of the base layer along a boundary between the hole processing area and the margin area; and
spraying an etchant to the boundary to form a module hole, wherein the patterning of the cover layer is performed by a photoresist process.

15. The method of claim 14, wherein the encapsulation layer comprises a first inorganic layer, an organic layer on the first inorganic layer, and a second inorganic layer on the organic layer, the first inorganic layer and the second inorganic layer are in contact with each other in the margin area, and the second inorganic layer overlapping the margin area is exposed via an opening formed through the cover layer in the patterning of the cover layer, optionally wherein the organic layer has a thickness equal to or greater than 5 micrometers and equal to or smaller than 10 micrometers, and the cover layer has a thickness equal to or greater than 2 micrometers and equal to or smaller than 5 micrometers.
